# EUROPEAN PATENT APPLICATION

(11) **EP 2 061 041 A1**
(43) Date of publication of application: **20.05.2009**
(21) Application number: 08703650.5
(22) Date of filing: 22.01.2008
(51) Int. Cl.: H01B 5/14, C23C 14/08, H01B 13/00

(54) **CONDUCTIVE FILM AND METHOD FOR PRODUCTION OF CONDUCTIVE FILM**

(30) Priority: 26.02.2007 JP 2007046010
(71) Applicant: Murata Manufacturing Co. Ltd., Nagaokakyo-shi, Kyoto 617-8555 (JP)
(72) Inventor: KISHIMOTO, Yutaka c/o (A170) Intellectual Property Department, Nagaokakyo-shi, Kyoto-fu 617-8555 (JP); FUKAHORI, Souko c/o (A170) Intellectual Property Department, Nagaokakyo-shi, Kyoto-fu 617-8555 (JP)
(74) Representative: Schoppe, Fritz
(86) International application number: PCT/JP2008/050806
(87) International publication number: WO 2008/105198

(57) **Abstract**

A ZnO-based conductive film and a method for manufacturing the film having an acceptable moisture resistance in practical use, properties required for a transparent conductive film, and economical advantage are provided.

[Means for Solving the Problems] A first ZnO conductive film layer 1, which includes ZnO as a main component and a Group III oxide as a dopant or includes ZnO as a main component and no Group III oxide, is formed on a surface of a substrate 11 and a second ZnO conductive film layer 2, which is transparent and includes a Group III oxide different to the Group III oxide included in the first conductive film layer is formed on the first ZnO conductive film layer to form a conductive film 10 having a multi-layer structure.

The thickness of the first ZnO conductive film layer is 5 to 50 nm or less.

Furthermore, the second and following ZnO conductive film layers include zinc oxide (ZnO) as a main component and a Group III oxide at a concentration of 7 wt% or less.

The first ZnO conductive film layer is formed under a condition in which high crystallinity of the first ZnO conductive film layer can be obtained (for example, under heat treatment) so as to enhance the crystallinity of the second ZnO conductive film layer and following conductive film layers formed on the first ZnO conductive film layer.

## Description

### Technical Field

The present invention relates to a conductive film and a method for manufacturing the same, specifically, relates to a conductive film having a multi-layer structure including a plurality of ZnO conductive film layers composed of ZnO as a main component and a method for manufacturing the same.

### Background Art

Recently, transparent electrodes have been widely used in flat panel displays, solar cells, and the like. As a material for transparent electrodes, indium tin oxide (ITO) is widely used.

However, since indium is expensive and an exhaustible resource, transparent electrodes have been increasingly required to be composed of materials other than indium. Consequently, ZnO-based transparent electrodes that do not include indium but include Zn, which has a low price and can be stably supplied, have been developed as transparent electrodes.

Although ZnO of stoichiometric ratio is classified as a insulating material, ZnO can be turned into a conductive material by generating excessive electrons therein through oxygen vacancy or by replacing Zn with another element (by doping). Under the present situation, transparent electrodes composed of ZnO as a main component and having a resistivity ρ of 10⁻⁴ Ωcm order can be manufactured.

However, ZnO-based transparent conductive films have a problem that a moisture resistance thereof is insufficient in practical use. That is, since existing ZnO-based transparent conductive films have considerable oxygen vacancy, when placed under a high humidity condition, a decrease in carrier concentration due to adsorption of water (reoxidation) to places where oxygen are absent disadvantageously leads to a high electric resistance. An acceptable rough standard for the moisture resistance of transparent electrodes including ITO is thought to be that a fluctuation in the resistivity should be within ±10% after a test of 720 hours conducted at 85°C and 85%RH. However, ZnO-based transparent conductive films satisfying the rough standard have not yet been obtained.

Furthermore, if ZnO-based transparent conductive films are formed on flexible substrates that will be used in many applications in the future, since moisture can penetrate the flexible substrate, the ZnO-based transparent conductive films are further disadvantageously deteriorated because not only moisture penetrating from a surface of the transparent conductive films but also moisture penetrating through the flexible substrates negatively affects the ZnO-based transparent conductive films.

In order to solve the above-mentioned problems, several methods for improving the moisture resistance of ZnO-based transparent conductive films have been provided. The methods are divided into two groups as follows:
(1) methods for suppressing the moisture penetrating through the substrate by providing a SiN barrier film.
(2) methods for improving quality (crystallinity) of a ZnO film by forming the ZnO film through heat treatment.

As of now, however, ZnO-based transparent conductive films having practicable moisture resistance cannot be obtained.

As examples of the techniques imparting conductivity to ZnO films by doping elements, the following means are proposed.
(a) A method for reducing electric resistance with high controllability by doping impurities into a ZnO film (refer to Patent Document 1). When the ZnO film is formed using a molecular beam of ZnO or molecular beams of Zn and O, another molecular beam is additionally used. The additional molecular beam is composed of any one of the elements selected from Group IA (H), Group IIIA (B, Al, Ga, and In), and Group VII (F, Cl, I, and Br).
(b) A transparent conductor constituted by a substrate and transparent conductive films laminated thereon (refer to Patent Document 2). The transparent conductor is composed of zinc oxide doped with an element of Group VB or Group VIB classified in the periodic table. The atomic percentage of the above-mentioned element, which is the ratio of the number of atoms of the above-mentioned element to the total number of atoms of zinc and the above-mentioned element, is 0.1 to 10.
(c) A transparent conductive film constituting an organic EL device (refer to Patent Document 3). The organic EL device has a positive electrode, a negative electrode, and an organic layer therebetween on a substrate, and the positive electrode is composed of a material containing one or more oxides selected from oxides of Ir, Mo, Mn, Nb, Os, Re, Ru, Rh, Cr, Fe, Pt, Ti, W, and V.
(d) A transparent conductive material for transistors (refer to Patent Document 4). An example of the transparent conductive material is a conductive ZnO which is doped with any of elements selected from Group II, Group VII, Group I, and Group V or is not doped.
(e) A transparent conductive film constituted by a thin film of zinc oxide (refer to Patent Document 5). The thin film of zinc oxide has a condition of an axial orientation in which a ratio of a c-axis orientation to an a-axis orientation is 100 or more. Furthermore, the thin film is doped with at least one dopant selected from Group III elements such as aluminum, gallium, and boron and compounds containing a Group VII element.
(f) A hexagonal lamellar compound based on indium zinc oxide having an average thickness of 0.001 µm to 0.3 µm and an average aspect ratio (average length/average thickness) of 3 to 1000 (refer to Patent Document 6). In the hexagonal layered compound, which is represented by formula, (ZnO)m·In₂O₃ (m = 2 to 20), In or Zn may be replaced with at least one element selected from a group composed of Sn, Y, Ho, Pb, Bi, Li, Al, Ga, Sb, Si, Cd, Mg, Co, Ni, Zr, Hf, Sc, Yb, Lu, Fe, Nb, Ta, W, Te, Au, Pt, and Ge.
(g) A distributed electroluminescence element having a structure in which a luminescent layer, an insulating layer, and a back electrode are laminated in this order on a transparent electrode formed on a substrate (refer to Patent Document 7). The transparent electrode includes a plurality of layers constituted by a non-doped zinc oxide transparent conductive film and a doped zinc oxide transparent conductive film, which is doped with an element selected from a Group III element or a Group IV element, and the order of lamination is not limited. The luminescent layer is composed of a luminescent material dispersed in an organic high polymer binder.
(h) A transparent substrate with a multi-layer film constituted by transparent conductor thin films laminated on the transparent substrate (refer to Patent Document 8). The multi-layer film includes a first conductive layer composed of a transparent conductor serving as an outermost layer and a second conductive layer composed of a transparent conductor containing zinc oxide as a main component and formed under the first conductive layer.
(i) A gas barrier type low moisture permeable insulating transparent substrate for an electrode (refer to Patent Document 9). The transparent substrate includes a transparent thin film layer, which is constituted by a transparent thin film having a single-layer or a multi-layer composed of silicon nitride and a transparent thin film having a single-layer or a multi-layer composed of any of materials selected from indium oxide, indium tin oxide (ITO), tin oxide, zinc oxide, aluminum oxide, silicon oxide, titanium oxide, zirconium oxide, tantalum oxide, niobium oxide, and selenium oxide; a transparent polymer layer; another transparent thin film layer; and another transparent substrate laminated in this order on the transparent substrate.

These ZnO-based transparent conductive films mentioned above actually have the same problems, to some extent, with respect to moisture resistance mentioned above.
Patent Document 1: Japanese Unexamined Patent Application Publication No. 7-106615
Patent Document 2: Japanese Unexamined Patent Application Publication No. 8-050815
Patent Document 3: Japanese Unexamined Patent Application Publication No. 11-067459
Patent Document 4: Japanese Unexamined Patent Application Publication No. 2000-150900
Patent Document 5: Japanese Unexamined Patent Application Publication No. 2000-276943
Patent Document 6: International Publication No. 2001/056927 pamphlet
Patent Document 7: Japanese Unexamined Patent Application Publication No. 3-053495
Patent Document 8: Japanese Unexamined Patent Application Publication No. 2005-047178
Patent Document 9: Japanese Unexamined Patent Application Publication No. 8-068990

### Disclosure of Invention

### Problems to be Solved by the Invention

The present invention provides a ZnO-based conductive film and a method for manufacturing the film that can solve the above-mentioned problems. The ZnO-based conductive film has moisture resistance for practical use, properties required for a transparent conductive film, and an advantage in terms of economical efficiency.

### Means for Solving the Problems

In order to solve the above-mentioned problems, the conductive film of the present invention (claim 1) has:
a multi-layer structure including two or more ZnO conductive film layers, the layers being formed on a substrate, wherein
a first ZnO conductive film layer is formed on a surface of the substrate, the first ZnO conductive film layer including ZnO as a main component and a Group III oxide as a dopant or including ZnO as a main component and no Group III oxide; and
a second ZnO conductive film layer is formed on the first conductive film layer, the second ZnO conductive film layer being transparent and including a Group III oxide as a dopant different to the Group III oxide included in the first conductive film layer.

The conductive film of claim 2 including a structure according to claim 1 of the present invention further includes a third ZnO conductive film layer being transparent, containing a Group III oxide as a dopant different to the Group III oxide contained in the second ZnO conductive film layer, and formed on the second ZnO conductive film layer.

The conductive film of claim 3 including a structure according to claim 1 of the present invention further includes a ZnO conductive film layer composed of two or more transparent layers, containing a Group III oxide as a dopant different to the Group III oxide contained in adjacent conductive film layers, and formed on the second ZnO conductive film layer.

The conductive film of claim 4 includes a structure according to any one of claims 1 to 3 of the present invention, wherein the thickness of the first ZnO conductive film layer is 5 to 50 nm.

The conductive film of claim 5 includes a structure according to any one of claims 1 to 4 of the present invention, wherein the second and following ZnO conductive film layers other than the first ZnO conductive film layer include a zinc oxide (ZnO) as a main component and a Group III oxide at a concentration of 7 wt% or less.

The conductive film of claim 6 includes a structure according to any one of claims 1 to 5 of the present invention, wherein a full width at half maximum of a rocking curve of ZnO(002) is 5° or less.

The conductive film of claim 7 includes a structure according to any one of claims 1 to 6 of the present invention, wherein the main component of the substrate is at least one material selected from a group composed of glass, quartz crystal, sapphire, silicon, silicon carbide, polyethylene terephthalate, polyethylene naphthalate, polyethersulfone, polyimide, cycloolefin polymer, and polycarbonate.

The conductive film of claim 8 includes a structure according to any one of claims 1 to 7 of the present invention, wherein each of the ZnO conductive film layers is formed by a method selected from a group composed of sputtering, vapor deposition, evaporation ion plating, laser ablation, arc plasma vapor deposition, and plating.

The method for manufacturing a conductive film of claim 9 is:
a method according to any one of claims 1 to 8 and includes
the steps of forming the first ZnO conductive film layer under a condition in which high crystallinity of the first ZnO conductive film layer can be obtained so as to enhance the crystallinity of the second and following ZnO conductive film layers formed on the first ZnO conductive film layer and
forming the second and following ZnO conductive film layers on the first ZnO conductive film layer.

The method for manufacturing a conductive film of claim 10 includes steps according to claim 9 of the present invention, wherein the first ZnO conductive film layer is formed by a method selected from a group composed of sputtering, vapor deposition, evaporation ion plating, laser ablation, arc plasma vapor deposition, and plating while applying heat treatment to the first ZnO conductive film layer during the formation thereof and then the second and following ZnO conductive film layers are formed on the first ZnO conductive film layer by a method selected from a group composed of sputtering, vapor deposition, evaporation ion plating, laser ablation, arc plasma vapor deposition, and plating while applying heat treatment or no heat treatment during the formation thereof.

### Advantages

According to the transparent conductive film of the present invention (claim 1), since the conductive film of the present invention (claim 1) is constituted by a first ZnO conductive film layer, which is formed on a surface of the substrate and includes ZnO as a main component and a Group III oxide as a dopant or includes ZnO as a main component and no Group III oxide, and a second ZnO conductive film layer, which is transparent and includes a Group III oxide different to the Group III oxide included in the first conductive film layer, formed on the first ZnO conductive film layer, a ZnO-based conductive film having moisture resistance for practical use, properties required for a transparent conductive film, and an advantage in terms of economical efficiency can be obtained.

That is, when the conductive film is formed according to the structure described in claim 1 of the present invention, high crystallinity of the first ZnO conductive film can also be obtained in the second ZnO conductive film layer by forming the first ZnO conductive film layer under a condition in which high crystallinity of the first ZnO conductive film layer can be obtained so as to enhance the crystallinity of the second and following film layers formed on the first ZnO conductive film layer and a conductive film having high moisture resistance and high orientation can be efficiently manufactured.

Note that, in the present invention, since the first ZnO conductive film layer is provided in order to fulfill its function to enhance the crystallinity and moisture resistance of the second conductive film layer formed thereon, the first ZnO conductive film layer may of course contain Group III oxide as a dopant. In some cases, however, a ZnO film, which may not contain Group III oxide as a dopant, may be formed as the first ZnO conductive film layer.

According to the conductive film of claim 2, by forming a third ZnO conductive film layer being transparent, containing a Group III oxide as a dopant that is different to the Group III oxide contained in the second ZnO conductive film layer, and formed on the second ZnO conductive film layer, other desired properties can be imparted to the conductive film layer composed of a conductive film (a second ZnO conductive film layer) having high moisture resistance, high orientation, and transparency. This results in the present invention being more effective.

Note that it is found that when the third ZnO conductive film layer, which contains a Group III oxide as a dopant different to the Group III oxide contained in the second ZnO conductive film layer, is formed on the second ZnO conductive film layer, high crystallinity of the second ZnO conductive film layer can also be obtained in the third ZnO conductive film layer. The reason for the occurrence of the above-mentioned phenomenon, however, has not yet been found.

Furthermore, in the present invention, according to the conductive film of claim 3, a ZnO conductive film layer composed of two or more transparent layers, containing a Group III oxide as a dopant different to the Group III oxide contained in adjacent conductive film layers, and formed on the second ZnO conductive film layer can be formed. Accordingly, various properties can be obtained by applying the present invention.

It is also found that when two or more ZnO conductive film layers containing a Group III oxide as a dopant different to the Group III oxide contained in adjacent conductive film layers are formed on the second ZnO conductive film layer, high crystallinity of the second ZnO conductive film layer can also be obtained in the following ZnO conductive film layer.

Note that there are not any particular limitations regarding the combination of Group III oxides contained in adjacent conductive film layers as long as the Group III oxides are different from each other. Examples of structures of the conductive film include a structure in which two kinds of layers, each containing a different Group III oxide, may be laminated alternately or a structure in which each of the layers contains different kinds of Group III oxides.

Furthermore, as the conductive film described in claim 4, if the first ZnO conductive film layer has a thickness of 5 to 50 nm, the ZnO conductive film layer having high crystallinity and moisture resistance can be preferably obtained.

Note that if the thickness of the first ZnO conductive film layer comes to less than 5 nm, the high crystallinity obtained for the first ZnO conductive film layer may not be sufficiently obtained for the second ZnO conductive film layer. Therefore, it is preferable that the thickness of the first ZnO conductive film layer be 5 nm or more.

When the thickness of the first ZnO conductive film layer exceeds 50 nm, if the total thickness of the conductive film is constant, thicknesses of the second and following ZnO conductive film layers become relatively small which may cause problems, so that the desired properties cannot be obtained. Therefore, it is preferable that the thickness of the first ZnO conductive film layer be less than 50 nm.

That is, in the present invention, since the first ZnO conductive film layer is formed considering improvement of crystallinity, orientation, and moisture resistance of the second and following ZnO conductive film layers formed on the first ZnO conductive film layer rather than considering properties such a low electric resistivity, if the thickness of the first ZnO conductive film layer can be reduced to 50 nm or less, the improvement of the properties such as moisture resistance can preferably be achieved without losing any suitable properties such as low electric resistivity of the entire conductive film.

Furthermore, according to the conductive film of claim 5, the function of the first ZnO conductive film layer, which improves the crystallinity and orientation of the second ZnO conductive film layer and following conductive film layers, can be sufficiently realized by regulating the content of Group III oxide in the second and following ZnO conductive film layers other than the first ZnO conductive film layer to 7 wt% or less. Therefore, a suitable conductive film having suitable properties can be obtained without fail.

Note that if the doping content of the Group III oxide is increased, the electric resistivity is relatively increased. If the doping content exceeds 7 wt%, the electric resistivity is increased and problems occur in practical use. Therefore, the content of the Group III oxide is preferably 7 wt% or less.

If the doping content of the Group III oxide is undesirably decreased, the conductive film cannot maintain its properties in some cases. Therefore, generally, the doping content is preferably 0.5 wt% or more. However, occasionally, a doping content of 0.5 wt% or less may be acceptable.

According to the conductive film of claim 6, if a full width at half maximum of a rocking curve of ZnO(002) is 5° or less, a conductive film having high moisture resistance and high orientation can be provided.

In the present invention, as described in claim 7, a substrate having a main component including at least one material selected from a group composed of glass, quartz crystal, sapphire, silicon, silicon carbide, polyethylene terephthalate, polyethylene naphthalate, polyethersulfone, polyimide, cycloolefin polymer, and polycarbonate can be used, and according to the present invention, a ZnO-based conductive film having moisture resistance for practical use and an advantage in terms of economical efficiency can be formed on the substrate composed of the above-mentioned materials.

In the present invention, as described in claim 8, each of the ZnO conductive film layers can be formed by a method selected from a group composed of sputtering, vapor deposition, evaporation ion plating, laser ablation, arc plasma vapor deposition, and plating. Accordingly, a conductive film having high moisture resistance and high orientation, that is, a conductive film having advantageous properties can be efficiently manufactured.

Furthermore, as described in claim 9 concerning a method for manufacturing a conductive film, when the conductive film according to any one of claims 1 to 8 is manufactured, if the first ZnO conductive film layer is formed under a condition in which high crystallinity of the first ZnO conductive film layer can be obtained so as to enhance the crystallinity of the second and following conductive film layers formed on the first conductive film layer and the second ZnO conductive film layer and following conductive film layers are formed on the first ZnO conductive film layer, high crystallinity of the first ZnO conductive film layer can be obtained in the second ZnO conductive film layer and a conductive film having high moisture resistance and high orientation can be efficiently manufactured.

Note that when two or more ZnO conductive film layers containing a Group III oxide as a dopant different to the Group III oxide contained in adjacent conductive film layers are further formed on the second ZnO conductive film layer, high crystallinity of the second ZnO conductive film layer can be obtained in the following ZnO conductive film layer and a conductive film having desired properties and a multi-layer structure of three layers or more can be efficiently manufactured.

Furthermore, as described in claim 10 concerning a method for manufacturing a conductive film, when the first ZnO conductive film layer is formed by a method selected from a group composed of sputtering, vapor deposition, evaporation ion plating, laser ablation, arc plasma vapor deposition, and plating while applying heat treatment to the first ZnO conductive film layer during the formation thereof and then the second and following ZnO conductive film layers are formed on the first ZnO conductive film layer by a method selected from a group composed of sputtering, vapor deposition, evaporation ion plating, laser ablation, arc plasma vapor deposition, and plating while applying heat treatment or no heat treatment during the formation thereof, high crystallinity obtained for the first ZnO conductive film layer can also be efficiently obtained for the second ZnO conductive film layer and following conductive film layer without fail. That results in the present invention being more effective.

That is, by applying heat treatment, the first ZnO conductive film layer having high crystallinity can be surely formed. Although the second ZnO conductive film layer may be formed by applying heat treatment, the second ZnO conductive film layer can also be formed under room temperature without applying heat treatment because the high crystallinity and the other properties obtained for the first ZnO conductive film layer may also be obtained for the second ZnO conductive film layer. This results in a highly efficient manufacturing process.

There are other methods for forming the first ZnO conductive film layer having high crystallinity other than heat treatment. Examples of these methods include optimizations of pressure, doping content, dopant species, power supply, and bias power applied to a substrate.

Furthermore, considerable effect can be obtained by using the above-mentioned methods in combination with heat treatment.

### Brief Description of Drawings

Fig. 1 is a graph showing relationship between doping content of Ga₂O₃ and resistivity or other properties of a ZnO conductive film.
Fig. 2 is a graph showing relationship between doping content of Al₂O₃ and resistivity or other properties of the ZnO conductive film.
Fig. 3 is a graph showing measured relationship between doping content of Ga₂O₃ and Al₂O₃ and resistivity of the ZnO conductive film.
Fig. 4 is a graph showing results of a moisture resistance test (85°C, 85%RH), in which relationship between elapsed time and percentage of resistance change of a ZnO conductive film having a single-layer structure is indicated.
Fig. 5 is a graph showing results of a moisture resistance test (85°C, 85%RH), in which relationship between elapsed time and percentages of resistance change of ZnO conductive films of the present invention having a two-layer structure and of a comparative example having a single-layer structure are indicated.
Fig. 6 is a view of a ZnO conductive film having a two-layer structure on the substrate according to an example (EXAMPLE 1) of the present invention.
Fig. 7 is a schematic view of a plurality of ZnO conductive film layers which are additionally formed on the two-layer structure of the ZnO conductive films shown in Fig. 6.

### Reference Numerals

1 first ZnO conductive film layer
2 (2a) second ZnO conductive film layer
2b, 2c ZnO conductive film layer formed on the second ZnO conductive film
11 substrate

### Best Mode(s) for Carrying Out the Invention

The features of the present invention will be further described in detail below with respect to embodiments of the present invention.

For the transparent conductive film of the present invention, which is a zinc oxide film formed on a substrate and doped with a Group III oxide, representative examples of the dopant (Group III element) for ZnO include Ga, Al, and In.

When these Group III elements (Group III oxides) are doped into ZnO, since a divalent Zn atom is replaced with a trivalent positive ion and surplus electrons serve as carriers, the ZnO shows n-type conductivity. Furthermore, when the ZnO film is formed by a film deposition method such as a sputtering, vapor deposition, evaporation ion plating, laser ablation, arc plasma vapor deposition, CVD, or sol-gel method under the condition in which oxygen gas having stoichiometrically lower concentration is supplied, oxygen vacancy occurs in the resulting film. Therefore, electrons therein serve as carriers and the ZnO also shows n-type conductivity.

Therefore, the ZnO doped with a Group III element becomes an n-type semiconductor having carriers supplied by doping ZnO with donor-type impurity, which generates electrons by replacing with Zn atoms, and by generation of electrons caused by oxygen vacancy.

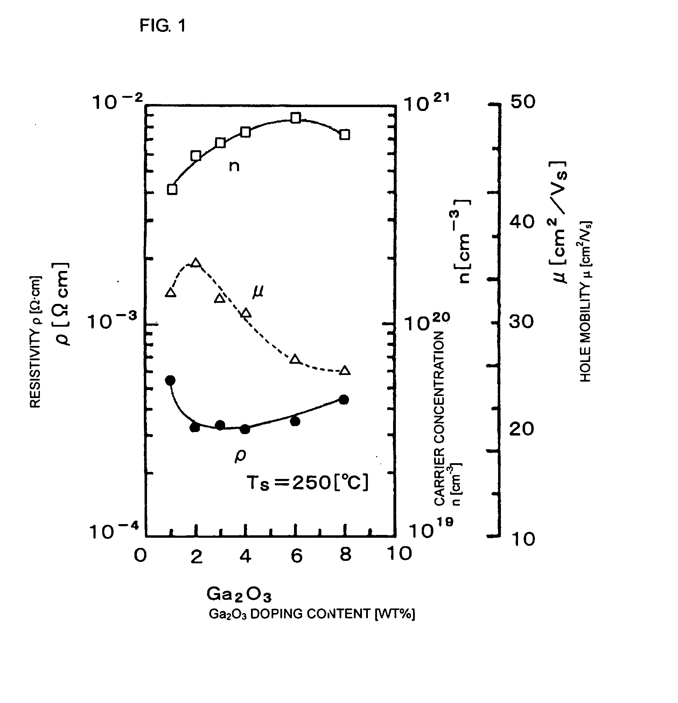

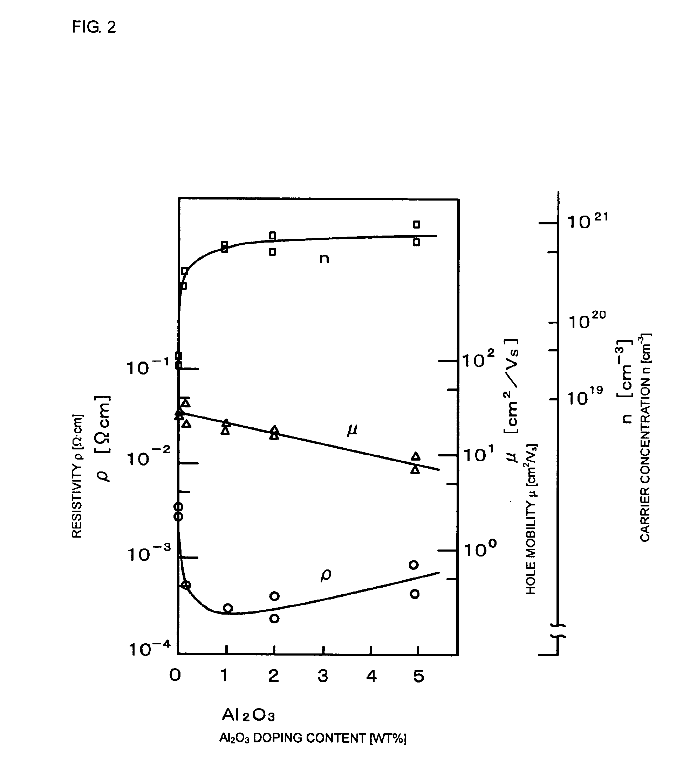

In the case that the dopant is, for example, Ga or Al, the relationship between the doping content and physical properties of a conductor including zinc oxide (ZnO) and doped with a Group III element is described in, "Tadatsugu Minami, et al., J. Vac. Soc., Vol. 47, No. 10, (2004) 734." According to the document, as shown in Fig. 1 and Fig. 2 of the present invention, the electric resistivity becomes lowest when the doping content is 2 to 4 wt% in terms of Ga₂O₃ (refer to Fig. 1) and the doping content is 1 to 3 wt% in terms of Al₂O₃ (refer to Fig. 2). Therefore, when considering that the conductor is applied to a transparent conductive film, it is advantageous to adjust the doping content to 2 to 4 wt% in terms of Ga₂O₃ or 1 to 3 wt% in terms of Al₂O₃ for obtaining a ZnO film with low resistivity.

However, it is found that when the doping content is decreased, the ZnO conductive film shows a considerable decrease in moisture resistance.

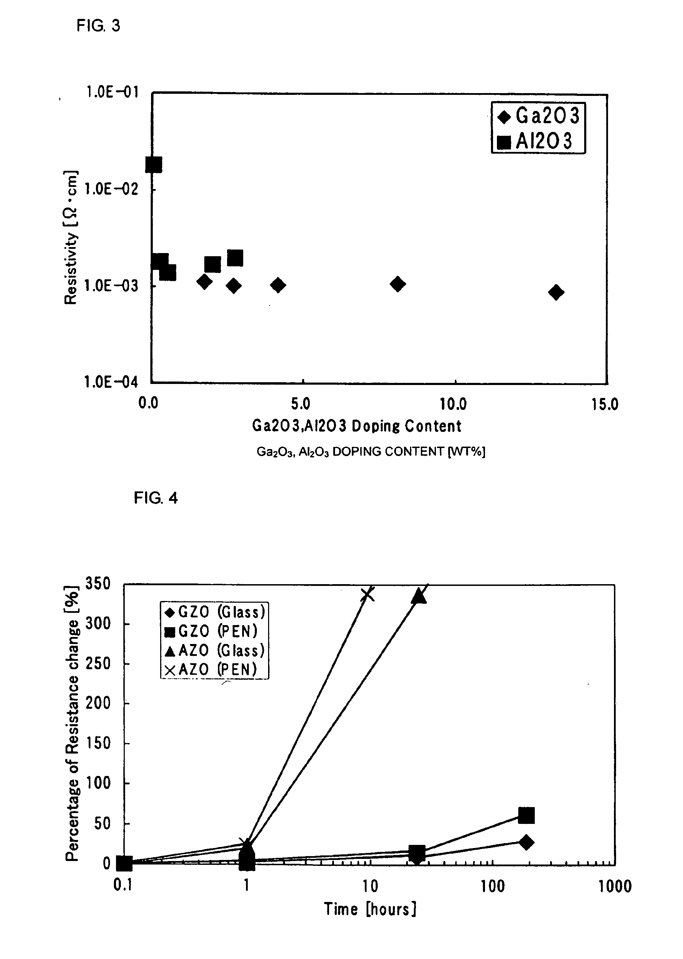

For example, a trace test conducted with reference to the above-mentioned document shows that the ZnO conductive film has the lowest electric resistivity as shown in Fig. 3, when the doping content is substantially the same as the content described in the above-mentioned document.

Next, a high-temperature high-humidity test (85°C, 85%RH) was conducted for a ZnO conductive film doped with 3.5 wt% Ga₂O₃ (hereinafter referred to as "GZO film") and a ZnO conductive film doped with 0.5 wt% Al₂O₃ (hereinafter also referred to as "AZO film").

As a result, it was found that after 200 hours, the electric resistance of the GZO film changed by about 30% on a glass substrate and by about 60% on a PEN (polyethylene naphthalate) substrate that is a flexible substrate (Fig. 4).

It was also found that after 200 hours, the electric resistance of the AZO film changed by about 1200% on a glass substrate and by about 5400% on a PEN substrate. The ZnO conductive film showing such a large change in electric resistance does not have practical use.

Considering that the deterioration in the electric resistance of the ZnO conductive film shown in the moisture resistance test may probably be caused by chemical instability as a result of oxygen vacancy, methods involving intentional introduction of water into a vacuum chamber in order to terminate the oxygen vacancy or heating of substrate in order to facilitate crystallization thereof were performed on ZnO conductive films which are doped with Ga or Al at a fixed concentration to achieve the above-mentioned lowest resistivity thereof. Any methods were not very effective.

In such a situation, a focus attention is made on water molecules that penetrate into grain boundaries of ZnO and trap electrons, which is a main cause of the instability of electric resistance in the moisture resistance test, and it is considered that the instability of electric resistance can be solved by enhancing crystallinity thereof and flattening a surface of the ZnO conductive film so as to reduce the amount of the grain boundaries. Accordingly, when a method was performed, which reduces the instability of electric resistance of the ZnO conductive film by forming a multi-layer structure serving as the ZnO conductive film layer, the moisture resistance of the ZnO conductive film was considerably improved. That is, for such a multi-layer structure, by providing a ZnO thin film (ZnO conductive film) serving as an initial film layer (first ZnO conductive film), which has suitable crystallinity obtained by applying heat treatment or the like, on the surface of the substrate, that is, under an existing ZnO conductive film (ZnO thin film) having the lowest electric resistance, the suitable crystallinity of the initial film layer can be transferred to the upper layer. As a result, a ZnO conductive film having low electric resistance, high orientation, and suitable moisture resistance can be obtained.

That is, if the method of the present invention is applied, a ZnO conductive film having significantly high moisture resistance and high crystallinity can be obtained by using a sintered mixed target such as a ZnO-Ga₂O₃ target with a doping content of 5.7 wt% in terms of Ga₂O₃, depositing a film having a thickness of 40 nm under a temperature of 250°C by sputtering, forming a first ZnO conductive film layer (ZnO conductive film layer doped with Ga₂O₃) serving as the initial film layer, depositing a film under room temperature up to a thickness of 360 nm on the first ZnO conductive film by a method similar to that mentioned above using a sintered mixed ZnO-Al₂O₃ target with a doping content of 3.0 wt% in terms of Al₂O₃, and forming a second ZnO conductive film layer (ZnO conductive film layer doped with Al₂O₃).

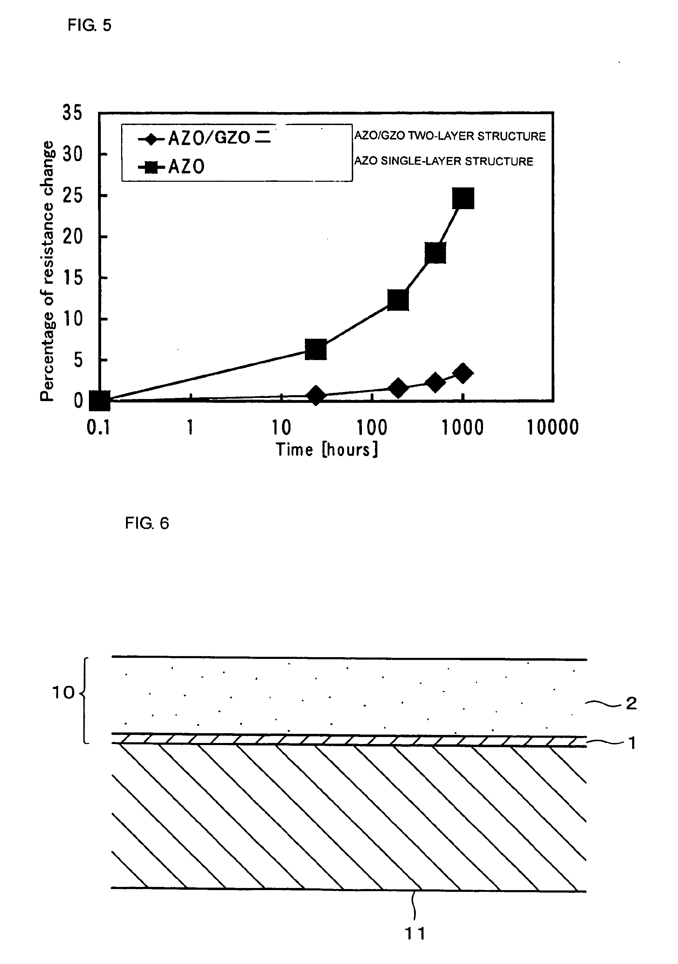

Note that the percentage of resistance change, which was measured after a 200-hour moisture resistance test, of the ZnO conductive film obtained by the above-mentioned method is, as shown in Fig. 5, as low as 2% or lower. This indicates that the ZnO conductive film has a high moisture resistance.

The features of the present invention will be further described in detail below with respect to specific examples. EXAMPLE 1

Fig. 6 is a view of a conductive film formed on a substrate according to an example (EXAMPLE 1) of the present invention.

As shown in Fig. 6, a conductive film 10 of EXAMPLE 1 has a two-layer structure composed of a first ZnO conductive film layer 1 being transparent, formed on a surface of a substrate 11, and including ZnO as a main component and a Group III oxide as a dopant and a second ZnO conductive film layer 2 being transparent, formed on the first ZnO conductive film layer 1, and including a Group III oxide as a dopant different to the Group III oxide included in the first conductive film layer.

Note that, in EXAMPLE 1, a glass substrate made of alkali-free glass (Corning 1737) was used for the substrate 11.

A ZnO conductive film was formed on a surface of the glass substrate 11 as the first ZnO conductive film layer 1 doped with Ga₂O₃ as a Group III oxide.

Furthermore, another ZnO conductive film was formed on the first ZnO conductive film layer 1 as the second ZnO conductive film layer 2 doped with Al₂O₃ as a dopant, which is a Group III oxide different to that included in the first ZnO conductive film layer 1.

Next, a method for manufacturing a conductive film having a multi-layer structure shown in Fig. 6 is described.

First, a glass substrate made of alkali-free glass (Corning 1737) was prepared as a substrate.

Then, a surface of the glass substrate was cleaned with isopropyl alcohol and UV irradiation.

A ZnO-Ga₂O₃ sintered mixed target (target provided for manufacturing a ZnO conductive film doped with Ga₂O₃) with a doping content of 35.7 wt% and a sintering density of 80% or more and a ZnO-Al₂O₃ sintered mixed target (target provided for manufacturing a ZnO conductive film doped with Al₂O₃) with a doping content of 3.0 wt% were prepared as sputtering targets.

Then the above-mentioned glass substrate was set in a chamber for deposition, and the chamber was evacuated to 5×10⁻⁵ Pa. Then, a ZnO conductive film was formed by sputtering.

In a step of deposition, the first layer formed on the glass substrate, which was a first ZnO conductive film layer serving as an initial film layer, was deposited by sputtering using the ZnO-Ga₂O₃ sintered mixed target. The first ZnO conductive film layer was heated while sputtering was performed at a temperature of 250°C. The ZnO conductive film layer doped with Ga₂O₃ (GZO film), which was formed on a surface of the glass substrate, was transparent and had a thickness of 40 nm.

After the step of deposition of the first ZnO conductive film layer, a ZnO conductive film layer doped with Al₂O₃ (AZO film), which was transparent and had a thickness of 360 nm, was deposited on the first ZnO conductive film layer by sputtering using the ZnO-Al₂O₃ sintered mixed target without performing heat treatment.

Through these steps, a two-layer structure ZnO conductive film (hereinafter also referred to as "AZO/GZO two-layer structure conductive film") was obtained. This film was constituted by the first ZnO conductive film (GZO film) layer being transparent and the second ZnO conductive film (AZO film) layer also being transparent formed thereon.

In the step of forming the above-mentioned first and second conductive films, high purity Ar gas as a sputtering gas was introduced into the chamber for deposition to form a pressure of 0.1 Pa and then sputtering was performed at an electric power of 3 W/cm².

The set thickness of the AZO/GZO two-layer structure conductive film was 400 nm, which is the sum of the thickness of the first ZnO conductive film layer and the thickness of the second ZnO conductive film layer. The resulting AZO/GZO two-layer structure conductive film was patterned by wet etching so that the thickness thereof could be measured using a stylus profilometer. The two-layer structure conductive film was confirmed to have the desirable thickness.

Note that a sample whose surface is entirely covered with the two-layer structure conductive film was additionally formed so as to evaluate the reliability of the measurement (electric resistance). The sample was used in a measurement of electric resistance which was performed with a four-point probe resistance meter.

The electric resistance (sheet resistance) of the AZO/GZO two-layer structure conductive film, which was measured with the four-point probe resistance meter, was 18.6 Ω/□ on average at the surface and the resistivity was 7.6×10⁻⁴ Ωcm.

The light transmittance in a visible range of the above-mentioned AZO/GZO two-layer structure conductive film was as high as 80% or more.

In order to analyze the crystallinity of the above-mentioned AZO/GZO two-layer structure conductive film, an X-ray diffraction (XRD) method was used. The full width at half maximum of the rocking curve measured in the ϕ direction was 4.7° (the full width at half maximum of the rocking curve measured in the ω direction was 2.89°).

Contrary to this, in the case of a ZnO conductive film doped with Al₂O₃ (AZO single-layer structure conductive film) having the same thickness (400 nm), formed on a glass substrate, and formed under the same conditions (without heating) as the conditions under which the above-mentioned second ZnO conductive film layer was formed, the full width at half maximum of the rocking curve measured in the ϕ direction was 27.7°.

When the AZO/GZO two-layer structure conductive film and the AZO single-layer structure conductive film were compared, it was found that the crystallinity of the AZO/GZO two-layer structure conductive film was considerably improved compared with that of the AZO single-layer structure conductive film. It was confirmed that the high crystallinity obtained for the first ZnO conductive film layer serving as the first layer was obtained for the second ZnO conductive film layer serving as the second layer.

Furthermore, each surface roughness Ra of the AZO/GZO two-layer structure conductive film and the AZO single-layer structure conductive film was measured with an atomic force microscope (AFM). The Ra of the AZO/GZO two-layer structure conductive film was 0.79 nm and that of the AZO single-layer structure conductive film was 2.10 nm. This indicates a significant improvement in the surface flatness of the film having a two-layer structure.

Furthermore, a moisture resistance test was performed on the AZO/GZO two-layer structure conductive film and the AZO single-layer structure conductive film. The results are shown in Fig. 5.

Note that the result of the moisture resistance test conducted on the AZO single-layer structure conductive film is additionally shown in Fig. 5 for comparison.

As shown in Fig. 5, the percentage of resistance change, which was measured after a 200-hour moisture resistance test, of the AZO single-layer structure conductive film is as high as about 12%. Contrary to this, the percentage of resistance change measured after 200-hour moisture resistance test of the AZO/GZO two-layer structure conductive film formed on a glass substrate is as low as about 1.5%. These results show a significant improvement in moisture resistance.

Note that, in EXAMPLE 1, the first ZnO conductive film layer serving as the initial film layer formed on a surface of the glass plate serving as a substrate was formed by heat treatment that is generally thought to be a method for forming a film having the highest crystallinity. However, if any of the other conditions, for example, pressure, doping content, dopant species, power supply, and bias power applied to a substrate are optimized when the bottom layer is formed, the above-mentioned effect will be more pronounced.

### EXAMPLE 2

EXAMPLE 1 describes a case where a glass plate is used as a substrate on which a conductive film is formed. EXAMPLE 2 describes another case where a PEN (polyethylene naphthalate) flexible substrate is used as a substrate on which a conductive film is formed. By a method similar to those used in the above-mentioned EXAMPLE 1, PEN substrates were subjected to a preparation treatment and sputtered under the same conditions as those performed in EXAMPLE 1. An AZO/GZO two-layer structure conductive film and an AZO single-layer structure conductive film were formed on the flexible substrates composed of PEN.

Properties of each conductive film were investigated using a method similar to those used in the above-mentioned EXAMPLE 1. Measurement results similar to those obtained from EXAMPLE 1 were obtained. It was found that if the conductive film is formed on a flexible substrate composed of PEN, a ZnO conductive film constituted by an AZO/GZO two-layer structure film has high crystallinity and high moisture resistance compared with a ZnO conductive film constituted by an AZO single-layer structure conductive film.

### EXAMPLE 3

EXAMPLE 1 describes a case where a glass plate is used as a substrate on which a conductive film is formed and EXAMPLE 2 describes a case where a PEN flexible substrate is used as a substrate on which a conductive film is formed. EXAMPLE 3 describes another case where a PET (polyethylene terephthalate) flexible substrate is used as a substrate on which a conductive film is formed. By a method similar to those used in the above-mentioned EXAMPLES 1 and 2, PET substrates were subjected to a preparation treatment and sputtered under the same conditions as those performed in EXAMPLE 1. An AZO/GZO two-layer structure conductive film and an AZO single-layer structure conductive film were formed on the flexible substrates composed of PET.

In EXAMPLE 3, similarly to EXAMPLES 1 and 2, when a flexible substrate composed of PET (polyethylene terephthalate) was used as a substrate, it was found that a ZnO conductive film constituted by an AZO/GZO two-layer structure film has high crystallinity and high moisture resistance compared with a ZnO conductive film constituted by an AZO single-layer structure conductive film.

Accordingly, it was found that an acceptable conductive film in practical use can be formed on a flexible substrate composed of PET (polyethylene terephthalate), which is widely used.

Note that the above-mentioned EXAMPLES describe the cases where the ZnO conductive films are formed on flexible substrates composed of a glass, PEN, or PET. However, the substrate is not limited to those mentioned above and the present invention can be applied to a case where a ZnO conductive film is formed on other kinds of substrates.

Although Ga₂O₃ or Al₂O₃ are used as a dopant in the above-mentioned EXAMPLES, other Group III oxides, such as indium oxide can be used as a dopant.

Furthermore, although the above-mentioned EXAMPLES describe cases where the ZnO conductive film is constituted by an AZO/GZO two-layer structure conductive film, an additional ZnO conductive film layer or two or more additional ZnO conductive film layers can be formed on the two-layer structure conductive film.

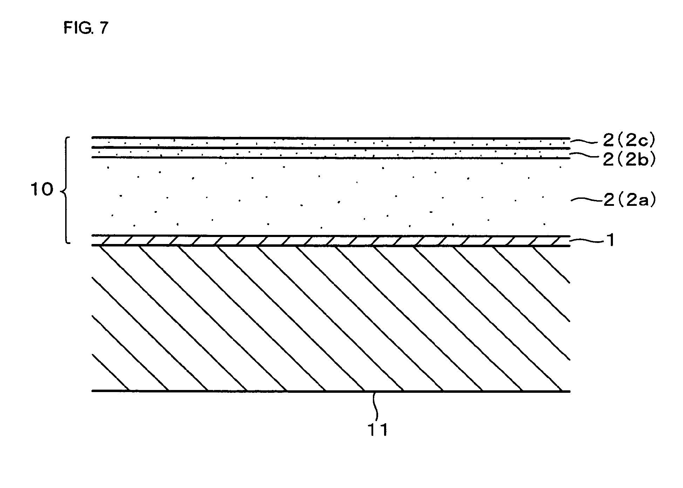

Fig. 7 is a schematic view illustrating a state in which a plurality (2 layers) of ZnO conductive film layers 2(2b, 2c) are additionally formed on the two-layer structure ZnO conductive film 2(2a) shown in Fig. 6.

When the additional ZnO conductive film layers (2b, 2c, etc.) are formed on the two-layer structure ZnO conductive film 2(2a), as shown in Fig. 7, the third and following ZnO conductive film layers (2b, 2c, etc.) should be deposited such that the third and following ZnO conductive film layers have a Group III oxide as a dopant different to that of adjacent ZnO conductive film layers in order to obtain a transparent conductive film layer having a high crystallinity and high moisture resistance.

Furthermore, although the above-mentioned EXAMPLES describe cases where the first ZnO conductive film layer includes a Group III oxide (Ga₂O₃) as a dopant, in some cases, a ZnO conductive film layer that does not have a Group III oxide as a dopant can be formed as the first ZnO conductive film layer.

The present invention is not limited to the above-mentioned EXAMPLES with respect to other aspects of the present invention. Various applications and modifications can be made within the scope of the present invention with respect to the shape and kind of material of a substrate having the ZnO conductive film thereon, kind or doping content of a Group III element, and specific deposition condition of a ZnO conductive film.

### Industrial Applicability

As described above, according to the present invention, a ZnO-based transparent conductive film having an acceptable moisture resistance in practical use, properties required for a transparent conductive film, and economical advantage can be manufactured surely and effectively.

Therefore, the present invention can be widely used in various applications such as transparent electrodes used for flat panel displays and solar cells.

## Claims

1. A conductive film having a multi-layer structure comprising two or more ZnO conductive film layers, the layers being formed on a substrate wherein
a first ZnO conductive film layer is formed on a surface of the substrate, the first ZnO conductive film layer including ZnO as a main component and a Group III oxide as a dopant or including ZnO as a main component and no Group III oxide; and
a second ZnO conductive film layer is formed on the first conductive film layer, the second ZnO conductive film layer being transparent and including a Group III oxide as a dopant different to the Group III oxide included in the first conductive film layer.

2. The conductive film according to claim 1, further comprising a third ZnO conductive film layer being transparent, containing a Group III oxide as a dopant different to the Group III oxide contained in the second ZnO conductive film layer, and formed on the second ZnO conductive film layer.

3. The conductive film according to claim 1, further comprising a ZnO conductive film layer composed of two or more transparent layers, containing a Group III oxide as a dopant different to the Group III oxide contained in adjacent conductive film layers, and formed on the second ZnO conductive film layer.

4. The conductive film according to any one of claims 1 to 3, wherein the thickness of the first ZnO conductive film layer is 5 to 50 nm.

5. The conductive film according to any one of claims 1 to 4, wherein the second and following ZnO conductive film layers other than the first ZnO conductive film layer include a zinc oxide (ZnO) as a main component and a Group III oxide at a concentration of 7 wt% or less.

6. The conductive film according to any one of claims 1 to 5, wherein a full width at half maximum of a rocking curve of ZnO(002) is 5° or less.

7. The conductive film according to any one of claims 1 to 6, wherein the main component of the substrate is at least one material selected from a group composed of glass, quartz crystal, sapphire, silicon, silicon carbide, polyethylene terephthalate, polyethylene naphthalate, polyethersulfone, polyimide, cycloolefin polymer, and polycarbonate.

8. The conductive film according to any one of claims 1 to 7, wherein each of the ZnO conductive film layers is formed by a method selected from a group composed of sputtering, vapor deposition, evaporation ion plating, laser ablation, arc plasma vapor deposition, and plating.

9. A method for manufacturing a conductive film according to any one of claims 1 to 8, the method comprising the steps of:
forming the first ZnO conductive film layer under a condition in which high crystallinity of the first ZnO conductive film layer can be obtained so as to enhance the crystallinity of the second and following ZnO conductive film layers formed on the first ZnO conductive film layer; and
forming the second and following ZnO conductive film layers on the first ZnO conductive film layer.

10. The method for manufacturing a conductive film according to claim 9, wherein the first ZnO conductive film layer is formed by a method selected from a group composed of sputtering, vapor deposition, evaporation ion plating, laser ablation, arc plasma vapor deposition, and plating while applying heat treatment to the first ZnO conductive film layer during the formation thereof and then the second and following ZnO conductive film layers are formed on the first ZnO conductive film layer by a method selected from a group composed of sputtering, vapor deposition, evaporation ion plating, laser ablation, arc plasma vapor deposition, and plating while applying heat treatment or no heat treatment during the formation thereof.
